Europäisches Patentamt

European Patent Office

Office européen des brevets

(11) Veröffentlichungsnummer: **0 338 343 B1**

## EUROPÄISCHE PATENTSCHRIFT

(45) Veröffentlichungstag der Patentschrift: **23.12.92**

(51) Int. Cl.⁵: **H05K 7/20**

(21) Anmeldenummer: **89106121.0**

(22) Anmeldetag: **07.04.89**

(54) **Kühleinschubeinheit für Schalt- und Steuerschränke.**

(30) Priorität: **20.04.88 DE 8805202 U**

(43) Veröffentlichungstag der Anmeldung:
**25.10.89 Patentblatt 89/43**

(45) Bekanntmachung des Hinweises auf die
Patenterteilung:
**23.12.92 Patentblatt 92/52**

(84) Benannte Vertragsstaaten:
**AT CH DE FR LI**

(56) Entgegenhaltungen:
**DE-A- 2 809 362**
**DE-A- 3 504 207**

(73) Patentinhaber: **Behr GmbH & Co.**
**Mauserstrasse 3**
**W-7000 Stuttgart 30(DE)**

(72) Erfinder: **Müllejans, Herbert, Dr.-Ing.**
**Gebelsbergstrasse 78**
**W-7000 Stuttgart 1(DE)**
Erfinder: **Prokopp, Alexander**
**Gartenstrasse 23**
**W-7149 Freiberg/Neckar(DE)**

(74) Vertreter: **Dreiss, Hosenthien & Fuhlendorf**
**Gerokstrasse 6**
**W-7000 Stuttgart 1(DE)**

**Beschreibung**

Die Erfindung betrifft eine Kühleinschubeinheit mit genormter Abmessung für einen Schaltschrank mit elektronischen Meß-, Schalt, und/oder Regelgeräten, die mindestens einen Wärmetausher und ein Luftumwälzgebläse aufweist, wobei die durch das Luftumwälzgebläse transportierte Luft ggf. durch Leitbleche zwischen dem Wärmetauscher und dem bzw. den Luftumwälzgebläsen geführt ist und ein Kühlmittelkreislauf vorgesehen ist, durch den über den Wärmetauscher Wärme abführbar ist.

Bei einer aus der CH-PS 639 517 bekannten solchen Kühleinschubeinheit wird als Luftumwälzgebläse ein Axialgebläse verwendet, das zwei schräg eingebauten Wärmetauschern die abzukühlende Luft zuführt. Das Axialgebläse bedingt sehr große Abmessungen insbesondere in der Höhe der Kühleinschubeinheit,so daß sehr viel Einschubplatz erforderlich ist. Die Kühlluftführung im Schaltschrank erfolgt in vertikaler Richtung durch die einzelnen untereinander angeordneten, zu kühlenden Aggregate hindurch. Die einzelnen Aggregate werden daher stark unterschiedlich gekühlt, insbesondere kann es sein, daß die letzten Aggregate mehr erwärmt als gekühlt werden, da die umgewälzte Luft bereits durch die im Luftstrom vorher durchströmten Aggregate stark aufgeheizt sein kann.

Im Vermeidung der geschilderten Nachteile liegt der vorliegenden Erfindung die Aufgabe zugrunde, eine Kühleinschubeinheit der eingangs genannten Art so zu verbessern, daß bei geringem Bauvolumen eine optimale Schaltschranktemperierung mit geringem Aufwand ermöglicht wird.

Zur Lösung dieser Aufgabe sieht die Erfindung vor, daß das Luftumwälzgebläse ein Radialgebläse ist und daß die Kühleinschubeinheit quer von der zu kühlenden Luft durchströmt ist und daß dazu auf einer Seite die Luft angesaugt und auf der gegenüberliegenden Seite die abgekühlte Luft ausgeblasen wird.

Bei einer entsprechenden Luftführung im Schaltschrank werden dann die einzelnen Einschübe entsprechend quer durchströmt, so daß jeder Einschub frisch abgekühlte Kühlluft zugeführt erhält und die erwärmte Abluft auf der gegenüberliegenden Seite über das Luftumwälzgebläse zur Abkühlung zum Wärmetauscher zurückgeführt wird.

Dadurch, daß das Luftumwälzgebläse als Querstromgebläse ausgebildet wird, dessen Achse parallel zum Wärmetauscher angeordnet ist, kann bei über dem Strömungsquerschnitt gleichmäßigen Kühlluftdurchsatz eine besonders flache Bauweise erreicht werden.

Besonders vorteilhaft kann dann eine Seitenwand der Kühleinschubeinheit Lufteinlaßöffnungen aufweisen, und es können in der gegenüberliegenden Seite Luftauslaßöffnungen vorgesehen sein, wobei die Öffnungen über Leitbleche mit dem Luftumwälzgebläse in Verbindung stehen können, um eine saubere Luftführung zu gewährleisten und damit eine gleichmäßige Kühlwirkung im Innenraum des Schaltschranks zu erhalten. Zur Material- und Gewichtseinsparung können diese Leitbleche durch entsprechend geformte Oberseiten und/oder Unterseiten bzw. Seitenwände der Kühleinschubeinheit direkt gebildet sein.

Bei einer weiteren Ausführungsform kann das Radialgebläse auf einer zur Ober- und Unterseite parallelen Zwischenwand angeordnet sein. Dabei kann die zentrale Ansaugöffnung des Radialgebläses duch die Zwischenwand geführt sein, wobei der Zwischenraum zwischen der Zwischenwand und der Unterseite der Einbaueinheit mit einer die Lufteinlaßöffnungen aufweisenden Seitenwand in Verbindung stehen kann.

Zur Erzielung eines über die Tiefe des Schaltschranks gleichmäßigen Luftstroms können im Raum zwischen Einschub und Wand Führungsbleche vorgesehen sein, die ggf. mit der Oberseite, der Unterseite, oder den Seitenwänden integriert sein können.

Zur Anpassung an örtlich unterschiedlichen Wärmeanfall können auch entsprechend angepaßte Führungsflächen vorgesehen sein, so daß die Luftabsaugung bzw. Kühlluftzuführung im Bereich der Wärmequelle besonders hoch ist.

Weitere erfindungsgemäße Ausbildungen sind den Unteransprüchen zu entnehmen und werden mit ihren Vorteilen anhand der beigefügten Zeichnungen in der nachstehenden Beschreibung näher erläutert. Es zeigt:

Fig. 1        einen schematisierten Schnitt durch eine Kühleinschubeinheit,

Fig. 2 und 3  der Fig. 1 entsprechende Ansichten Ausführungsformen von Kühleinschubeinheiten und

Fig. 4        eine Draufsicht auf die in Fig. 3 dargestellte Kühleinschubeinheit mit Radialgebläse.

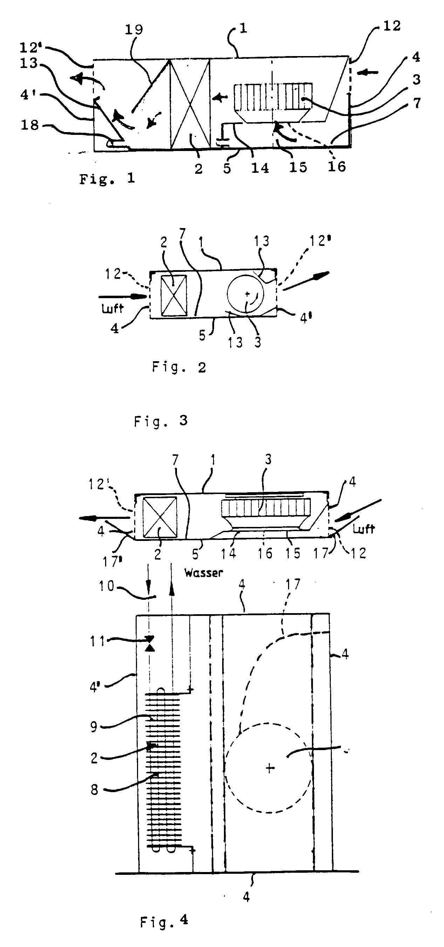

Für alle im folgenden beschriebenen Ausführungsformen werden für entsprechende Teile die gleichen Bezugszeichen verwendet. Die Kühleinschubeinheit weist eine dicht ausgebildete Oberseite 1 und Unterseite 5 auf, zwischen denen ein Wärmetauscher 2 und ein Luftumwälzgebläse 3 angeordnet sind. Das als Radialgebläse ausgebildete Luftumwälzgebläse 3 ist auf einer Zwischenwand 14 angeordnet, die einen Zwischenraum 15 bildet, der mit einer Lufteinlaßöffnung 12 mit dem Schaltschrankinneren und durch eine zentrale Ansaugöffnung 16 direkt mit dem Laufrad des Luftumwälzgebläses 3 in Verbindung steht. Entsprechend den eingezeichneten Pfeilen wird die Luft vom Luftumwälzgebläse 3 durch den Wärmetauscher 2 hindurch gedrückt entlang einer Tropfenfangwand 19 nach unten und über ein Leitblech 13 schräg nach oben zu einer Luftauslaßöffnung 12' geführt. Die Lufteinlaßöffnung 12 und die Luftauslaßöffnung 12' sind in gegenüberliegenden Seitenwänden 4,4' mit Abstand von der Unterseite 5 angeordnet, so daß die Unterseite 5 und die Seitenwände 4 eine Tropfwanne 7 bilden, die über eine Wasserabführleitung 18 entwässert werden kann, die auch durch die Zwischenwand 14 geführt ist. Insbesondere durch die Anordnung der Tropfenfangwand 19 und dem Leitblech 13 wird bei einem eventuellen Bruch der durch den Wärmetauscher 2 geführten Wasserleitung 8 (Fig.4) das austretende Kühlmittel aufgefangen und abgeleitet und es wird ein Herausspritzen nach außen durch die Luftauslaßöffnung 12' verhindert, so daß am Schaltschrank keinerlei Wasserschäden auftreten können.

Beim Ausführungsbeispiel der Fig. 2 ist parallel zum Wärmetauscher 2 das als Querstromgebläse ausgebildete Luftumwälzgebläse 3 angeordnet, durch das durch Lufteinlaßöffnungen 12 in der linken Seitenwand 4 Luft durch den Wärmetauscher 2 hindurch angesaugt und abgekühlt durch Leitbleche 13 geführt durch Luftauslaßöffnungen 12' in der rechten Seitenwand 4' abgeführt wird. Es erfolgt also immer eine Querförderung der Luft in der Kühleinschubeinheit. Durch die Verwendung von Querstromgebläsen ist eine sehr flache und schmale Bauweise der Kühleinschubeinheit besonders raumsparend möglich.

Beim in den Fig. 3 und 4 dargestellten Ausführungsbeispiel dient als Luftumwälzgebläse 3 ein Radialgebläse, das auf der horizontalen Zwischenwand 14 angeordnet ist, so daß zwischen dieser Zwischenwand 14 und der Unterseite 5 ein Zwischenraum 15 mit Führungsblechen 17 gebildet ist, der über Lufteinlaßöffnungen 12 in der rechten Seitenwand 4 nach außen verbunden ist. Das Luftumwälzgebläse 3 ist über eine zentrale Ansaugöffnung 16, die in Fig. 3 nicht näher dargestellt ist, mit dem Zwischenraum 15 in Verbindung, so daß vom Zwischenraum 15 Luft abgesaugt und durch den Wärmetauscher 2 und die Luftauslaßöffnung 12' in der linken Seitenwand 4' nach links weggeblasen werden kann, wie dies durch die Pfeile in Fig. 3 angedeutet ist. Die Anordnung des Wärmetauschers 2 mit der Wasserleitung 8 und den Kühllamellen 9 sowie einem thermostatischen Magnetventil 11 ist in Fig. 4 dargestellt.

Die Wasserleitung 8 wird beim Einschub der Kühleischubeinheit in einen Schaltkasten automatisch mit den entsprechend angeordneten Vorsorgungsleitungen gekoppelt, ebenso wie die elektrischen Zuführungen für Energie und Steuerung.

Durch die Anordnung von Führungsflächen 17,17', die mit der Oberseite 1 oder der Unterseite 5 integriert sein können, kann eine gleichmäßige, oder aber bei örtlich stark unterschiedlichem Wärmeanfall auch eine gezielte örtliche höhere Luftströmung durch die Öffnungen 12,12' erzielt werden.

**Patentansprüche**

1. Kühleinschubeinheit mit genormter Abmessung für einen Schaltschrank mit elektronischen Meß-, Schalt-, und/oder Regelgeräten, die mindestens einen Wärmetauscher (2) und ein Luftumwälzgebläse (3) aufweist, durch das Luft durch den Wärmetauscher (2) geführt wird und ein Kühlmittelkreislauf vorgesehen ist, durch den über den Wärmetauscher (2) Wärme abführbar ist, **dadurch gekennzeichnet,** daß das Luftumwälzgebläse (3) ein Radialgebläse ist und daß die Kühleinschubeinheit quer von der zu kühlenden Luft durchströmt ist und daß dazu auf einer Seite die Luft angesaugt und auf der gegenüberliegenden Seite die abgekühlte Luft ausgeblasen wird.

2. Kühlschubeinheit nach Anspruch 1, dadurch gekennzeichnet, daß das Luftumwälzgebläse (3) ein Querstromgebläse ist, dessen Achse parallel zum Wärmetauscher (2) angeordnet ist.

3. Kühleinschubeinheit nach Anspruch 1 oder 2, dadurch gekennzeichnet, daß eine Seitenwand (4) Lufteinlaßöffnungen (12) aufweist und in der gegenüberliegenden Seitenwand (4') Luftauslaßöffnungen (12) vorgesehen sind und daß die Öffnungen (12,12') Über Leitbleche (13) mit dem Luftumwälzgebläse (3) in Verbindung stehen.

4. Kühleinschubeinheit nach Anspruch 1, dadurch gekennzeichnet, daß das als Radialgebläse ausgebildete Luftumwälzgebläse (3) auf einer zur Oberseite (1) und Unterseite (5) etwa parallelen Zwischenwand (14) angeordnet ist.

5. Kühleinschubeinheit nach Anspruch 4, dadurch gekennzeichnet, daß eine zentrale Ansaugöffnung (16) des Radialgebläses durch die Zwischenwand (14) geführt ist und daß der Zwischenraum (15) zwischen dieser Zwischenwand (14) und der Unterseite (5) mit einer mindestens eine Lufteinlaßöffnung (12) aufweisenden Seitenwand (4) verbunden ist.

6. Kühleinschubeinheit nach einem der Ansprüche 1 bis 5, dadurch gekennzeichnet, daß Führungsbleche (17,17') für eine gleichmäßige Luftführung über dem gesamten Querschnitt der Lufteinlaßöffnungen (12) bzw. Luftauslaßöffnungen (12') vorgesehen sind.

7. Kühleinschubeinheit nach Anspruch 6, dadurch gekennzeichnet, daß an die örtlich anfallende Wärmebelastung angepaßt die Führungsbleche (17,17') vorgesehen und ggf. zweckentsprechend geformt sind.

8. Kühleinschubeinheit nach einem der Ansprüche 1 bis 7, dadurch gekennzeichnet, daß die Unterseite (5) und mindestens ein Teil der Seitenwände (4,4') als Tropfwanne (7) zum Auffangen von Wasser, insbesondere Kondenswasser ausgebildet und mit einer Wasserabführleitung (18) verbunden ist.

9. Kühleinschubeinheit nach Anspruch 8, dadurch gekennzeichnet, daß durch die Wasserabführleitung (18) auch am Wärmetauscher (2) kondensierendes Wasser abgeleitet wird.

10. Kühleinschubeinheit nach Anspruch 8, dadurch gekennzeichnet, daß die Luftauslaßöffnungen (12') im oberen Bereich der Seitenwand (4') vorgesehen sind und daß zwischen dem Wärmetauscher (2) und der Luftauslaßöffnung (12') eine vorzugsweise geneigt verlaufende Tropfenabfangwand (19) vorgesehen ist.

11. Kühleinschubeinheit nach einem der Ansprüche 1 bis 10, dadurch gekennzeichnet, daß die Leitflächen (13) und/oder Führungsbleche (17,17') durch die zweckentsprechend geformte Oberseite (1), die Unterseite (5) und/oder eine der Seitenwände (4,4') mindestens teilweise gebildet sind.

12. Kühleinschubeinheit nach einem der Ansprüche 1 bis 11, dadurch gekennzeichnet, daß der Wärmetauscher (2) eine mäanderförmige Wasserleitung (8) aufweist, die quer dazu verlaufende Kühllamellen (9) mehrfach durchdringt.

13. Kühleinschubeinheit nach einem der Ansprüche 1 bis 11, dadurch gekennzeichnet, daß das thermostatische Ventil (11) über ein temperaturabhängiges Dehnstoffelement temperaturgesteuert ist.

## Claims

1. A standard sized cooling rack for an electronic switchgear and control cabinet having at least one heat exchanger (2) and a forced air circulating blower (3) by which air is guided through the heat exchanger (2) to provide a coolant circuit by which heat can be removed through the heat exchanger (2), characterized in that the forced air circulating blower (3) is a radial fan, in that the cooling air traverses the cooling rack horizontally and in that for this purpose air is taken in on one side and the cooled air is blown out on the opposite side.

2. A cooling rack as claimed in claim 1, characterized in that the forced air circulating blower (3) is a centrifugal fan, the axis of which is arranged in parallel with the heat exchanger (2).

3. A cooling rack as claimed in either one of claims 1 or 2, characterized in that air intake openings (12) are provided in one side panel (4) and air outlet openings (12') are provided in the opposite side panel (4') and in that the openings (12,12') are connected with the forced air circulating blower (3) by air guides (13).

4. A cooling rack as claimed in claim 1, characterized in that the forced air circulating blower (3) comprising the radial fan is arranged on a partition (14) which is approximately parallel to the top side (1) and under side (5).

5. A cooling rack as claimed in claim 4, characterised in that a central intake opening (16) of the radial fan is led through the partition (14) and the intervening space (15) between this partition (14) and the under side (5) is connected with a side panel (4) having at least one air intake opening (12).

6. A cooling rack as claimed in any of claims 1 to 5, characterised in that guide plates (17,17') are provided for uniform guidance of air through the entire cross section of the air intake openings (12) and air outlet openings (12') respectively.

7. A cooling rack as claimed in claim 6, characterised in that the guide plates (17,17') are shaped appropriately to correspond to locally arising thermal load.

8. A cooling rack as claimed in any of claims 1 to 7, characterised in that the under side (5) and at least a part of the side panels (4,4') comprise a drip-water trough (7) for catching water, particularly condensed water, and is connected with a water drainage pipe (18).

9. A cooling rack as claimed in claim 8, characterised in that water condensing in the heat exchanger (2) is also drained off by the water drainage pipe (18).

10. A cooling rack as claimed in claim 8, characterised in that the air outlet openings (12') are provided within the upper section of the side panel (4') and in that a preferably inclined drip-collecting panel (19) is provided between the heat exchanger (2) and the air outlet opening (12').

11. A cooling rack as claimed in any of claims 1 to 10, characterised in that the guide surfaces (13) and/or guide plates (17,17') are at least partially formed by the purpose-shaped top side (1), the under side (5) and/or one of the side panels (4,4').

12. A cooling rack as claimed in any of claims 1 to 11, characterised in that the heat exchanger (2) comprises a wave-form water pipe (8) which repeatedly passes through cooling fins (9) arranged in perpendicular to it.

13. A cooling rack as claimed in any of claims 1 to 11, characterized in that the thermostatic valve (11) is thermally controlled by means of a temperature-dependent expanding-material element.

**Revendications**

1. Groupe de refroidissement en tiroir à dimensions normalisées pour une armoire de distribution comprenant des appareils électroniques de mesure, de commutation et/ou de réglage, ledit groupe comprenant au moins un échangeur de chaleur (2) et une soufflante (3) de circulation d'air en circuit fermé qui guide l'air à travers l'échangeur de chaleur (2) et un circuit d'agent réfrigérant étant prévu pour évacuer la chaleur par l'échangeur de chaleur (2), caractérisé en ce que la soufflante (3) de circulation d'air en circuit fermé est une soufflante radiale, en ce que le groupe de refroidissement en tiroir est balayé transversalement par l'air devant être refroidi et en ce qu'à cette fin l'air est aspiré d'un côté et l'air refroidi est refoulé du côté opposé.

2. Groupe de refroidissement en tiroir selon la revendication 1, caractérisé en ce que la soufflante (3) de circulation d'air en circuit fermé est une soufflante à courant transversal dont l'axe est parallèle à l'échangeur de chaleur (2).

3. Groupe de refroidissement en tiroir selon la revendication 1 ou 2, caractérisé en ce qu'une cloison latérale (4) comprend des ouvertures (12) d'admission d'air et des ouvertures (12') de sortie d'air sont prévues dans la cloison latérale opposée (4') et en ce que les ouvertures (12, 12') communiquent par des déflecteurs (13) avec la soufflante (3) de circulation d'air en circuit fermé.

4. Groupe de refroidissement en tiroir selon la revendication 1, caractérisé en ce que la soufflante (3) de circulation d'air en circuit fermé, qui est une soufflante radiale, est disposée sur une cloison intermédiaire (14) sensiblement parallèle au côté supérieur (1) et au côté inférieur (5).

5. Groupe de refroidissement en tiroir selon la revendication 4, caractérisé en ce que l'orifice central d'aspiration (16) de la soufflante radiale passe par la cloison intermédiaire (14) et en ce que l'espace (15) compris entre cette cloison intermédiaire (14) et le côté inférieur (5) communique avec une cloison latérale (4) comportant au moins une ouverture (12) d'admission d'air.

6. Groupe de refroidissement en tiroir selon l'une des revendications 1 à 5, caractérisé en ce que des tôles de guidage (17, 17') sont prévues pour un guidage régulier d'air sur la totalité de la section des ouvertures (12) d'admission d'air et des ouvertures (12') de sortie d'air.

7. Groupe de refroidissement en tiroir selon la revendication 6, caractérisé en ce que les tôles de guidage (17, 17') qui sont prévues sont adaptées à la charge thermique produite localement et éventuellement sont conformées en conséquence.

8. Groupe de refroidissement en tiroir selon l'une des revendications 1 à 7, caractérisé en ce que le côté inférieur (5) et au moins une partie des cloisons latérales (4, 4') sont conformés en cuvette d'égouttement (7) destinée à recueillir l'eau, en particulier l'eau de condensation, et reliée à un conduit (18) d'évacuation d'eau.

9. Groupe de refroidissement en tiroir selon la revendication 8, caractérisé en ce que le conduit (18) d'évacuation d'eau évacue aussi l'eau qui s'est condensée sur l'échangeur de chaleur (2).

10. Groupe de refroidissement en tiroir selon la revendication 8, caractérisé en ce que les ouvertures (12') de sortie d'air sont prévues à la partie supérieure de la cloison latérale (4') et en ce qu'une cloison (19) collectrice de gouttelettes, qui est de préférence inclinée, est prévue entre l'échangeur de chaleur (2) et l'ouverture (12') de sortie d'air.

**11.** Groupe de refroidissement en tiroir selon l'une des revendications 1 à 10, caractérisé en ce que les déflecteurs (13) et/ou les tôles de guidage (17, 17') sont formés au moins partiellement par le côté supérieur (1), le côté inférieur (5) et/ou l'une des cloisons latérales (4, 4') conformés en conséquence.

**12.** Groupe de refroidissement en tiroir selon l'une des revendications 1 à 11, caractérisé en ce que l'échangeur de chaleur (2) comprend un conduit d'eau (8) en forme de frettes qui traverse plusieurs fois les lamelles de refroidissement (9) qui sont disposées transversalement par rapport à ce conduit.

**13.** Groupe de refroidissement en tiroir selon l'une des revendications 1 à 11, caractérisé en ce que la vanne thermostatique (11) est commandée en fonction de la température par un élément en matériau expansible en fonction de la température.

Fig. 1

Fig. 2

Fig. 3

Wasser

Luft

Fig. 4